(19) Europäisches Patentamt
European Patent Office
Office européen des brevets

(11) Numéro de publication : **0 053 966**
**B1**

# (12) FASCICULE DE BREVET EUROPÉEN

(45) Date de publication du fascicule du brevet :
21.03.84

(21) Numéro de dépôt : **81401867.7**

(22) Date de dépôt : **25.11.81**

(51) Int. Cl.³ : **H 01 L 21/48**, H 01 L 21/68// H01L23/48

(54) **Machine automatique de cambrage des pattes de connexion de plaquettes de circuits intégrés.**

(30) Priorité : **05.12.80 FR 8025856**

(43) Date de publication de la demande :
**16.06.82 Bulletin 82/24**

(45) Mention de la délivrance du brevet :
**21.03.84 Bulletin 84/12**

(84) Etats contractants désignés :
**CH DE FR GB IT LI NL**

(56) Documents cités :
**FR-A- 2 299 724**
**US-A- 4 099 660**
**US-A- 4 166 562**
**IBM TECHNICAL DISCLOSURE BULLETIN, volume 19, no. 11, avril 1977, NEW YORK (US) E. PERLS et al. "Air track" pages 4184-4185**
**IBM TECHNICAL DISCLOSURE BULLETIN, volume 23, no. 1, juin 1980 NEW YORK (US) M. GAGNE et al. "Chip sensor" pages 110-111**

(73) Titulaire : **COMPAGNIE INTERNATIONALE POUR L'INFORMATIQUE CII - HONEYWELL BULL (dite CII-HB)**
**94, avenue Gambetta**
**F-75020 Paris (FR)**

(72) Inventeur : **Delorme, Raymond**
**94 avenue Gambetta**
**F-75020 Paris (FR)**

(74) Mandataire : **Denis, Hervé**
**94, avenue Gambetta**
**F-75020 Paris (FR)**

Jouve, 18, rue St-Denis, 75001 Paris, France

## Machine automatique de cambrage des pattes de connexion de plaquettes de circuits intégrés

La présente invention concerne une machine automatique de cambrage des pattes de connexion de plaquettes de circuits intégrés, en vue de la connexion de ces circuits sur une plaque présentant par exemple des circuits imprimés.

On sait réaliser des équipements électroniques, et plus particulièrement des ensembles de traitement de l'information, en utilisant des circuits intégrés non enfermés dans des boîtiers. Ces circuits intégrés sans boîtier sont désignés le plus souvent sous le nom de pastilles, de plaquettes de circuits intégrés, ou encore de « puces » (« chips »). Ces plaquettes sont généralement de forme rectangulaire ou carrée, leurs côtés mesurent quelques millimètres.

Pour faciliter la manipulation de ces plaquettes, dont les dimensions sont très faibles, et pour faciliter aussi leur contrôle puis leur montage sur une plaque de connexion telle qu'une plaque de circuits imprimés, ces plaquettes sont montées sur un support isolant généralement constitué par un ruban souple en matière isolante inextensible, pourvu pour son entraînement, de perforations latérales régulièrement espacées. Ce support est muni de fenêtres équidistantes au centre desquelles se trouvent les plaquettes. Ces plaquettes sont maintenues dans les fenêtres par un ensemble de conducteurs qui sont disposés en éventail autour de chacune d'elles et qui relient respectivement des plots de contact de ces plaquettes avec le support isolant, tout en soutenant chaque plaquette dans la fenêtre qui lui correspond. Généralement, pour réaliser les conducteurs qui relient les plots avec les bords des fenêtres réalisées dans le support ou ruban isolant, on lamine un ruban de cuivre de quelques centièmes de millimètres d'épaisseur sur un ruban dans lequel les fenêtres ont été préalablement découpées. Dans chacune de ces fenêtres, le ruban conducteur de cuivre est gravé par exemple chimiquement de façon à ne laisser subsister que des bandes conductrices qui forment les conducteurs précités, qui partent des bords de chaque fenêtre et qui aboutissent aux plots de la plaquette de circuits intégrés placée au centre de cette fenêtre. Chaque extrémité de ces conducteurs est soudée à l'un des plots de connexion de la plaquette considérée. Il en résulte que les plaquettes sont ainsi rendues solidaires du ruban servant de support et, lorsque l'on désire détacher l'une des plaquettes du ruban, il suffit de sectionner les conducteurs qui la relient au ruban à une certaine distance de ses bords, après un cambrage préalable des conducteurs ; ce cambrage est destiné à former des pattes facilitant la connexion des plaquettes sur une plaque de connexion ; c'est une opération délicate et, généralement, afin d'éviter que lors de cette opération les extrémités de conducteurs soudées préalablement sur les plots de chaque plaquette ne se détachent de ces plots, il est connu de réaliser sur chacun des conducteurs, au voisinage du bord de chaque fenêtre, une structure d'amortissement des contraintes mécaniques, solidaire du conducteur ; cette structure d'amortissement est constituée par exemple par au moins un anneau qui absorbe les forces d'élongation auxquelles sont soumis les conducteurs lors du cambrage. Les pattes de connexion sont formées dans chaque portion de conducteur qui s'étend du plot correspondant jusqu'au voisinage de la structure d'amortissement des contraintes mécaniques.

On sait réaliser ce cambrage au moyen d'une machine automatique qui comprend un socle de cambrage et des moyens mobiles de cambrage situés en regard de ce socle. Généralement, lorsque le support de plaquettes est constitué par un ruban, ce ruban est préalablement découpé à intervalles réguliers entre les plaquettes, de manière que chaque portion de ruban ainsi obtenue, présente une fenêtre au centre de laquelle se trouve une plaquette. Cette portion de ruban est alors fixée dans un cadre, et le cambrage des pattes des plaquettes est alors effectué en présentant chaque portion de ruban encadrée et munie d'une fenêtre comprenant une plaquette, dans la machine de cambrage. Dans cette machine, des moyens permettent de déplacer le support de plaquettes ainsi obtenu pour amener cette plaquette sur le socle dans une direction perpendiculaire à la plaquette, puis pour éloigner cette plaquette du socle, après cambrage. Dans ce type de machine, des moyens mécaniques, constitués par un poussoir en acier, par exemple, permettent de positionner et de maintenir en position la plaquette sur le socle durant l'opération de cambrage. Les moyens mobiles de cambrage sont constitués par des matrices mobiles qui courbent les conducteurs de manière à former des pattes dans une direction perpendiculaire à la plaquette.

Ce type de machine présente de nombreux inconvénients ; il est d'abord nécessaire de découper le ruban supportant les plaquettes en portions régulières présentant chacune une plaquette dont les pattes sont à courber ; chacune de ces portions doit être, préalablement au cambrage, enserrée dans un cadre et ce n'est qu'à partir de ce montage que les pattes de chacune des plaquettes sont ensuite courbées. Ces opérations sont longues et ne permettent pas d'effectuer les opérations de cambrage, en grande série. Un autre inconvénient résulte du fait que les plaquettes sont positionnées et maintenues pendant l'opération de cambrage grâce à un poussoir métallique qui, en s'appuyant sur la surface de la plaquette, risque de détériorer les circuits intégrés sur cette plaquette. Enfin, dans ce type de machine, les matrices de cambrage ne sont pas du tout agencées pour éviter que lors du cambrage, les soudures entre les extrémités des conducteurs et les plots des plaquettes ne subissent des contraintes et se détériorent. Ces contraintes ne sont que partiellement absorbées par les structures d'amortissement mentionnées plus haut.

La présente invention a pour but de remédier à ces inconvénients et notamment de réaliser une machine automatique de cambrage des pattes de connexion de plaquettes de circuits intégrés dans laquelle il est possible de faire défiler successivement, sans découpage préalable, le support ou ruban sur lequel sont montées les plaquettes, et dans laquelle des moyens permettent de coincer les pattes de la plaquette, au voisinage du pourtour de celle-ci, lors du cambrage, afin d'éviter que les soudures des extrémités des conducteurs sur les plots de contact de chacune des plaquettes, ne soient soumises à des contraintes risquant de détériorer ces soudures. Enfin, cette machine, grâce à l'utilisation de moyens pneumatiques de positionnement de plaquettes sur le socle de cambrage, permet d'éviter la détérioration de circuits intégrés lors du cambrage.

L'invention a pour objet une machine automatique de cambrage de pattes de connexion d'au moins une plaquette de circuits intégrés, destinée à être montée sur une plaque de connexion, cette plaquette étant préalablement montée sur un support isolant pourvu d'au moins une fenêtre, au centre de laquelle se trouve la plaquette, des conducteurs reliant des plots de contact de la plaquette avec le support isolant tout en soutenant la plaquette dans la fenêtre, une patte représentant une portion de conducteur qui s'étend du plot correspondant jusqu'au voisinage d'une structure d'amortissement des contraintes mécaniques, solidaire du conducteur et voisine du bord de la fenêtre, cette machine comprenant un socle de cambrage, des moyens mobiles de cambrage situés en regard du socle, des moyens pour déplacer le support de plaquettes et pour amener chaque plaquette sur le socle dans une direction perpendiculaire à la plaquette et dans un premier sens, et pour éloigner la plaquette après cambrage, dans ladite direction perpendiculaire et dans un deuxième sens opposé au premier sens, et des moyens pour positionner la plaquette sur le socle, caractérisé en ce que le socle de cambrage comprend un logement dont le pourtour épouse la forme du pourtour de la plaquette et un rebord plan est apte à entrer en contact avec les pattes à cambrer, au voisinage du pourtour de la plaquette, et en ce que les moyens mobiles de cambrage comprennent une première pièce mobile dans ladite direction perpendiculaire et dans les premier et deuxième sens, cette première pièce étant située en regard du socle et présentant un rebord plan correspondant au rebord plan du socle, de manière à coincer les pattes de la plaquette au voisinage du pourtour de la plaquette lors du cambrage, et une deuxième pièce mobile dans ladite direction perpendiculaire et dans les deux sens, cette deuxième pièce entourant la première pièce et permettant de cambrer les conducteurs de manière à former des pattes qui présentent chacune une cambrure qui épouse la forme du pourtour du rebord du socle, une partie linéaire se raccordant à cette cambrure dans une direction sensiblement perpendiculaire à la plaquette. Cette partie linéaire se raccordant de manière continue avec la portion restante de conducteur située entre cette partie linéaire et le support isolant, la première pièce circulant dans la deuxième pièce et des moyens élastiques étant interposés entre ces deux pièces pour appliquer à la première pièce une force s'opposant au mouvement relatif de la première pièce par rapport à la deuxième.

Selon une autre caractéristique de l'invention, les moyens qui permettent de positionner la plaquette sur le socle de cambrage sont constitués par des moyens pneumatiques de contrôle d'état et de positionnement, situés dans la première pièce et appliquant sur la plaquette un jet de fluide gazeux sous pression capable d'appliquer la plaquette dans son logement.

Selon une autre caractéristique, les moyens pour positionner la plaquette sur le socle de cambrage comprennent en outre des moyens automatiques de contrôle de présence de la plaquette.

Selon une autre caractéristique, les moyens pneumatiques de présence sont constitués par le contrôle des moyens pneumatiques pour appliquer sur la plaquette un jet de fluide gazeux dont la pression est inférieure à celle du jet de fluide gazeux de positionnement. Les moyens pneumatiques de contrôle de présence et de contrôle d'état et de positionnement de plaquette comprennent en outre un capteur de pression relié au logement du socle, et des moyens de détection de seuil de pression, associés à ce capteur pour indiquer un incident et interdire le cambrage en cas de mauvais positionnement de la plaquette dans le logement du socle, en cas d'absence de plaquette ou si cette plaquette présente un mauvais état de surface.

Selon une autre caractéristique, la sortie du détecteur est reliée à des moyens pour déplacer le support de plaquette, de sorte à arrêter la machine en cas d'incident.

Selon une autre caractéristique, le support de plaquette est constitué par un ruban souple et isolant inextensible muni de perforations latérales d'entraînement, les fenêtres dans lesquelles se trouvent les plaquettes se succédant dans une direction linéaire parallèle aux bords du ruban, les moyens qui permettent de déplacer le support étant constitués par un dispositif d'entraînement pas à pas agissant sur les perforations latérales pour déplacer le ruban dans ladite direction linéaire, pour amener successivement chaque plaquette en regard de ce socle, les moyens pour amener la plaquette sur le socle de cambrage comprenant une platine de positionnement du ruban, cette platine présentant des moyens de guidage linéaire du mouvement avec amortissement dans ladite direction perpendiculaire à la plaquette dans les premier et deuxième sens et présentant une ouverture en regard du logement du socle de cambrage, la deuxième pièce mobile de cambrage présentant des saillies aptes à s'engager dans les perforations de la bande qui sont voisines de chaque plaquette située en regard du socle de cambrage et à s'engager dans des logements réalisés dans la platine de positionnement en regard de ces saillies, cette deuxième pièce de cambrage comprenant en outre des moyens élastiques aptes à plaquer le ruban sur la platine de positionnement, lors du déplacement des première et deuxième pièces dans le premier sens pour le cambrage et lors du déplacement de ces pièces dans le deuxième sens, jusqu'à ce que les saillies soient dégagées des perforations, après cambrage.

Selon une autre caractéristique, les moyens de guidage linéaire et d'amortissement du mouvement de la platine comprennent un guide linéaire solidaire de cette platine et parallèle à ladite direction perpendiculaire à la plaquette, et des moyens élastiques d'amortissement du mouvement situés entre la platine et un bâti solidaire du socle de cambrage.

Selon une autre caractéristique, les moyens d'amortissement comprennent en outre un frein pneumatique agissant sur le guide linéaire.

Selon une autre caractéristique, les moyens élastiques pour plaquer le ruban sur la platine de positionnement, sont constitués par des doigts munis de ressorts, montés dans la deuxième pièce mobile de cambrage et agissant dans ladite direction perpendiculaire à la plaquette.

Selon une autre caractéristique, la machine comprend des moyens pneumatiques de commande des déplacements des première et deuxième pièces mobiles de cambrage dans la direction perpendiculaire à la plaquette et dans les premier et deuxième sens.

Selon une autre caractéristique, les moyens pneumatiques de contrôle d'état et de positionnement situés dans la première pièce mobile sont constitués par une première buse formée dans la première pièce mobile et alimentée par le fluide gazeux sous pression.

Selon une autre caractéristique, les moyens pneumatiques de contrôle de présence de plaquettes par pression de fluide gazeux comprennent une seconde buse située dans la première buse, présentant un orifice de dimension inférieure à celle de la première buse et alimentée par le même fluide gazeux sous pression, le logement du socle comprenant un conduit relié au capteur de pression.

D'autres caractéristiques et avantages de l'invention ressortiront mieux de la description qui va suivre, donnée en référence aux figures schématiques annexées, dans lesquelles :

la figure 1  représente une plaquette de circuits intégrés montée sur un support isolant ayant la forme d'un ruban perforé muni de fenêtres.

la figure 2  représente une structure d'amortissement des contraintes mécaniques, montée sur chaque conducteur, reliant la plaquette au ruban perforé.

la figure 3  représente le contact entre l'extrémité d'une patte de connexion, obtenue grâce à la machine de l'invention, avec un plot de contact d'un circuit imprimé sur une plaque de connexion.

la figure 4  représente de manière très schématique le cambrage des pattes de connexion, au voisinage de la plaquette.

la figure 5  représente schématiquement et en coupe, la machine automatique de cambrage, conforme à l'invention.

la figure 6  représente schématiquement et en coupe certains des moyens de la machine de l'invention, dans les positions qu'ils occupent au début des opérations de cambrage.

la figure 7  représente les moyens précédents, dans les positions qu'ils occupent pendant les opérations de cambrage.

la figure 8  représente les moyens précédents dans les positions qu'ils occupent au cours du cambrage et quand ce cambrage vient d'être effectué.

la figure 9  représente schématiquement les principaux moyens de commande de la machine de l'invention.

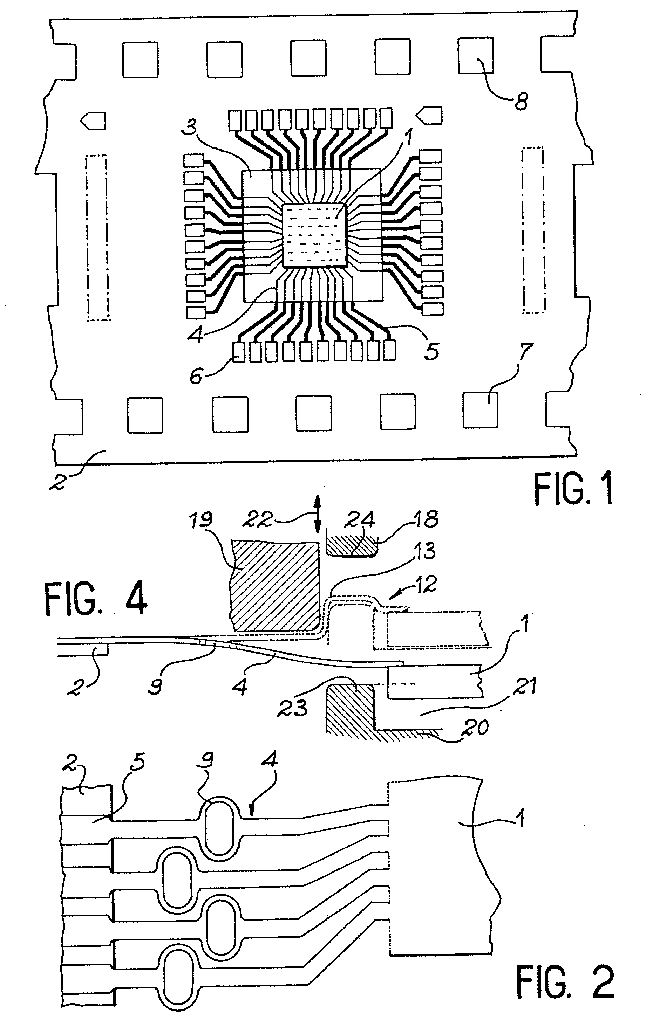

La figure 1 représente une plaquette de circuits intégrés, qui peut être qualifiée de micro-plaquette ou de « puce », montée sur un support isolant muni d'au moins une fenêtre 3, au centre de laquelle se trouve la plaquette. Des conducteurs 4 relient des plots de contact des circuits de la plaquette 1, avec le support isolant 2, tout en soutenant la plaquette dans la fenêtre 3. Ces conducteurs se prolongent sur le support isolant 2 par des bandes conductrices 5 reliées à des zones de contact 6 formées sur le support isolant. De manière connue, les conducteurs 4, les bandes conductrices 5 et les zones de contact 6 peuvent être réalisées par laminage d'une bande de cuivre sur le support 2, puis par gravure chimique de cette bande pour former les conducteurs, les bandes conductrices et les zones de contact. Dans une étape ultérieure, les extrémités libres des conducteurs 5 sont reliées aux plots de contact de la plaquette 1 (non représentés). Le support isolant 2 peut être constitué de manière connue par un ruban isolant souple et inextensible, tel que par exemple, le matériau polyamide fabriqué et vendu par la société DUPONT DE NEMOURS sous le nom de « KAPTON » (marque déposée). Ce ruban comporte en plus des fenêtres espacées régulièrement, des perforations latérales 7, 8, régulièrement espacées et destinées à en permettre l'entraînement par un dispositif approprié. Les zones de contact 6 permettent notamment de contrôler le fonctionnement des circuits intégrés sur la plaquette, avant le montage de chaque plaquette sur une plaque de connexion telle qu'un circuit imprimé par exemple. Sur cette figure, on suppose que les circuits sont situés sur la face de la plaquette qui est visible sur la figure. L'épaisseur du ruban isolant 2 est de l'ordre de quelques centièmes de millimètres, tandis que la plaquette présente des dimensions de quelques millimètres et que les conducteurs qui relient cette plaquette au ruban isolant, ont une épaisseur de quelques dizaines de microns.

La figure 2 représente des structures d'amortissement des contraintes mécaniques auxquelles sont soumis les conducteurs, notamment durant le cambrage. Ces structures sont constituées de manière connue par des anneaux 9 solidaires des conducteurs 4 et voisins du bord de la fenêtre réalisée dans le ruban 2 et au centre de laquelle se trouve la plaquette 1. Comme on le verra par la suite, les pattes sont constituées dans les portions de conducteurs 4 qui s'étendent entre les plots correspondants de la plaquette, jusqu'au voisinage des anneaux 9.

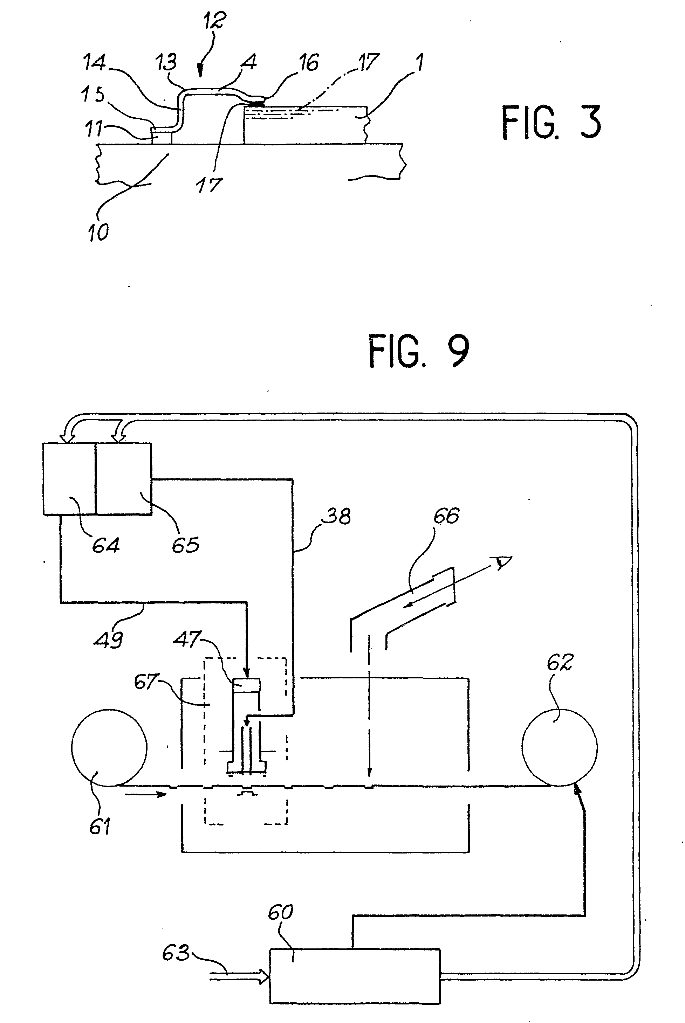

La figure 3 représente schématiquement le contact entre une patte 12 de la plaquette 1 et un plot de contact 11 d'une plaque de connexion 10, constituée par exemple par une plaque de circuits imprimés. Comme on le verra par la suite, chacune des pattes obtenue grâce à la machine de l'invention est formée d'une cambrure 13 suivie d'une partie linéaire 14, dans une direction sensiblement perpendiculaire à la plaquette, cette partie linéaire se raccordant avec la portion 15. On a représenté en 17 le plot de connexion d'une patte sur la plaquette de circuit intégré. La cambrure 13 se raccorde à la portion de conducteur qui s'étend jusqu'au plot 17.

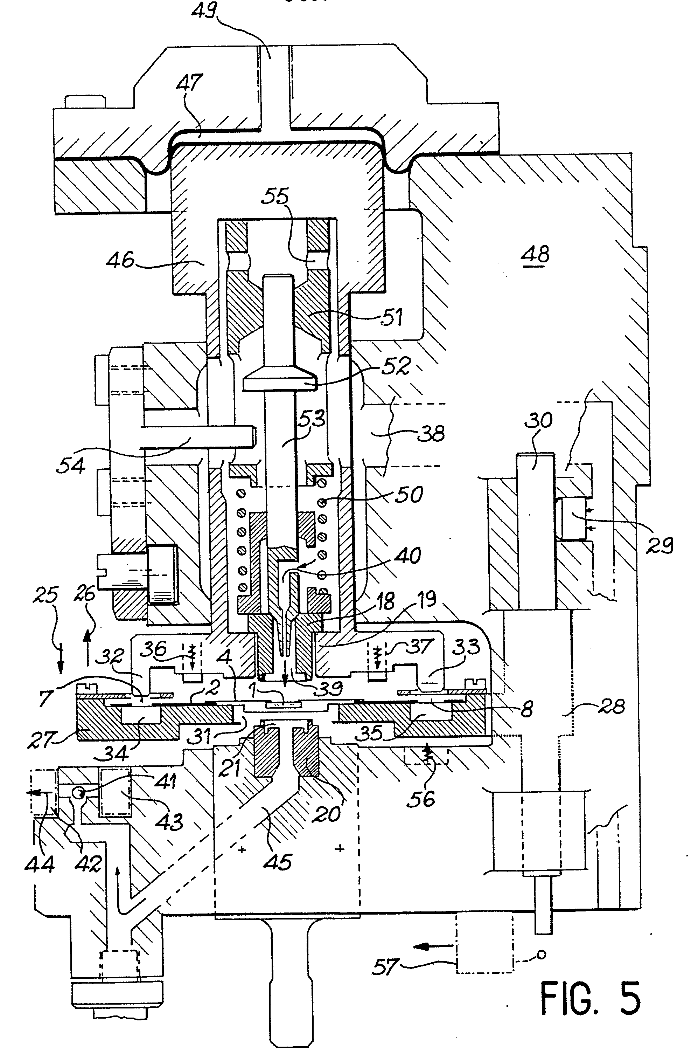

La figure 4 représente schématiquement une partie des moyens mobiles qui permettent de cambrer les pattes de la plaquette ; ces moyens mobiles de cambrage sont notamment constitués par une première pièce mobile 18 et par une deuxième pièce mobile 19 ; la première pièce mobile est située en regard d'un socle de cambrage 20 qui présente un logement 21 dont le pourtour épouse la forme du pourtour de la plaquette 1 et dont la profondeur est adaptée à l'épaisseur de la plaquette. On a également représenté sur cette figure, l'un des conducteurs 4 qui relie la plaquette au support ou ruban isolant 2. Les première et deuxième pièces mobiles 18, 19 de cambrage, peuvent être déplacées dans une direction perpendiculaire à la surface de la plaquette dans l'un des deux sens opposés indiqués par la double flèche 22. Ainsi qu'il apparaît sur la figure, le socle de cambrage 20 présente un rebord plan 23. Le socle 20 présente ainsi un rebord plan 24 en regard du rebord plan 23. Lors du cambrage, le rebord 24 de la première pièce mobile vient coincer les pattes de la plaquette, au voisinage du pourtour de celle-ci, tel que représenté en traits interrompus sur la figure. La deuxième pièce mobile 19 entoure la première pièce 18 de manière à cambrer les conducteurs pour former les pattes dont la forme a été décrite plus haut. La cambrure 13 épouse la forme extérieure du rebord 23 du socle 20 ; durant tout le cambrage, la soudure entre les extrémités des conducteurs 4 et les plots de contact de la plaquette 1 ne sont soumises à aucune contrainte, du fait que les conducteurs sont coincés entre la première pièce mobile 18 et le socle 20. Les contraintes auxquelles sont soumis les conducteurs durant le cambrage apparaissent au-delà de la surface de contact entre les conducteurs 4, la première pièce mobile 18 et le socle 20, du côté de la première pièce mobile 19 ; ces contraintes sont absorbées par les anneaux d'amortissement 9.

La figure 5 est une coupe longitudinale de la machine automatique de cambrage, conforme à l'invention. Sur cette figure, les mêmes références désignent les mêmes éléments que sur les figures précédentes. On distingue sur cette figure le socle de cambrage 20, la plaquette 1 reliée par les conducteurs 4 au ruban 2 dont les perforations latérales apparaissent en 7 et 8. La première pièce mobile de cambrage est représentée en 18, tandis que la deuxième pièce mobile qui est représentée en 19 sera décrite plus loin en détail. Cette machine est bien entendu associée à des moyens qui permettent de déplacer le ruban ou support de plaquettes dans une direction linéaire perpendiculaire au plan de figure, pour amener successivement chaque plaquette en regard du socle 20 ; ces moyens ne sont pas représentés sur la figure et seront décrits en référence à la figure 9. Ils sont principalement constitués par un dispositif d'entraînement pas à pas, agissant sur les perforations latérales 7, 8 pour déplacer le ruban dans la direction linéaire. Cette machine comprend également des moyens pour déplacer le support de plaquettes et pour amener chaque plaquette sur le socle, dans une direction perpendiculaire à la plaquette, dans le sens de la flèche 25. Ils permettent également d'éloigner la plaquette du socle, après cambrage dans le sens de la flèche 26, et ils comprennent tout d'abord une platine 27 de guidage du ruban 2, présentant des moyens de guidage linéaire 28 des mouvements dans la direction perpendiculaire à la plaquette. Le mouvement linéaire est amorti grâce à des moyens constitués par un frein pneumatique 29 agissant sur le guide linéaire 30 et par des moyens élastiques 56 (un ressort par exemple) situés entre la platine 27 et le bâti 48. La platine 27 présente une ouverture 31, en regard du socle de cambrage. La deuxième pièce mobile de cambrage 19 présente des saillies 32, 33 qui s'engagent dans les perforations 7, 8 de la bande 2, voisines de chaque plaquette qui est située en regard du socle 20 de cambrage ; ces saillies s'engagent également dans des logements 34, 35 réalisés dans la platine 27.

La deuxième pièce de cambrage 19 comprend également des moyens élastiques 36, 37 qui permettent de plaquer le ruban 2 sur la platine 27, lors du déplacement des première et deuxième pièces de cambrage 18, 19 dans le sens de la flèche 25, durant les opérations de cambrage ; ces moyens élastiques permettent aussi de maintenir ce ruban plaqué contre la platine 27 durant le déplacement des première et deuxième pièce de cambrage, dans le sens de la flèche 26, après cambrage, jusqu'à ce que les saillies 32, 33 soient dégagées des perforations 7, 8 du ruban 2. Ces moyens élastiques sont constitués par des doigts munis de ressorts, représentés de manière schématique sur la figure. Ces doigts agissent, bien entendu dans une direction perpendiculaire à la plaquette 1.

La machine comprend aussi des moyens qui permettent de positionner avec précision la plaquette 1 sur le socle de cambrage et plus précisément, dans le logement 21 de ce socle. Ces moyens sont pneumatiques et sont ici constitués par une première buse 39, alimentée en fluide gazeux sous pression, par le conduit 38, comme on le verra plus loin en détail. Les moyens qui permettent de positionner la plaquette sur le socle 20 comprennent en outre des moyens automatiques qui permettent de contrôler la présence de la plaquette sur le socle, le positionnement de celle-ci sur le socle, ainsi que son état. Ces moyens de contrôle sont situés dans la première pièce mobile 19, ils sont du type pneumatique et ils sont constitués ici par une buse 40 alimentée en fluide gazeux par le conduit 38 ; cette seconde buse qui est située dans la première buse, présente un orifice dont la dimension est inférieure à celle de la première buse, de manière à appliquer sur la plaquette un jet de fluide gazeux dont la pression est inférieure à celle du jet de fluide gazeux de la buse 39 et qui permet de positionner la plaquette sur le socle. Un capteur de pression constitué par une bille 41, située à une extrémité du conduit 42 qui débouche dans le logement 21, est associé à un détecteur infra-rouge 42, 43 ; ce capteur et ce détecteur permettent de détecter tout incident concernant la plaquette ; en effet, lorsqu'une plaquette est absente dans l'une des fenêtres, en regard du socle 20, ou lorsque cette plaquette est mal positionnée dans son logement ou qu'elle est en mauvais état et présente par exemple une fissure, le jet de fluide gazeux provenant de la buse 40, provoque à l'intérieur du conduit 45 une surpression qui fait remonter la bille 41, à l'extrémité du conduit ; cette remontée est détectée par le détecteur infra-rouge 42, 43. La bille agit comme un capteur de pression. Si un tel incident se produit, la sortie 44 du détecteur infra-rouge délivre un signal indiquant cet incident ; ce signal permet d'interdire comme on le verra par la suite, la descente des première et deuxième pièces de cambrage ; il permet également de commander les moyens qui agissent sur le déplacement du ruban ou support de plaquettes, de sorte qu'en cas d'incident, une autre plaquette ne soit pas amenée en regard du socle 20.

Enfin, la machine comprend des moyens pneumatiques de commande du déplacement des première et deuxième pièces mobiles 18, 19 dans une direction perpendiculaire à la plaquette.

Ces moyens de commande de déplacement des première et deuxième pièces mobiles de cambrage sont constitués par un piston 46, surmonté d'une chambre à air 47 et qui se déplace dans le bâti 48 de la machine. L'extrémité inférieure de ce piston est solidaire de la deuxième pièce de cambrage 19. La chambre à air 47 est alimentée en fluide gazeux sous pression par le conduit 49. Des moyens élastiques constitués par le ressort 50, sont interposés entre les première et deuxième pièces de cambrage 18, 19 ; ce ressort qui prend appui sur la première pièce 18 et sur une pièce intermédiaire 51 contenue dans le piston 46, applique à la première pièce 18, une force s'opposant au mouvement relatif de la première pièce par rapport à la deuxième pièce ; il est destiné à appliquer le rebord plan de la pièce 18 sur le rebord plan du socle 20, pour coincer les conducteurs durant le cambrage. Avant cambrage le jet de fluide gazeux sous pression, de la buse 40, permet le contrôle de la présence de la plaquette 1. Ensuite les pièces mobiles 18, 19 sont déplacées dans le sens de la flèche 25. Peu avant que la première pièce mobile 19 entre en contact avec le socle 20, en coinçant les conducteurs 4, un épaulement 52 de la tige 53, solidaire de la buse 40, vient en butée avec l'ergot 54. La position de cette tige, en hauteur, par rapport au socle 20 peut être réglée grâce à l'excentrique 5. Lorsque l'épaulement est en butée avec la tige 54, la partie conique de l'extrémité de la buse 40 cesse alors de s'appuyer sur le pourtour de la buse 39, et le jet de fluide gazeux sous pression de la buse 39, permet d'appliquer et de positionner la plaquette 1 dans le logement 21. Ce jet 39 permet alors de contrôler le positionnement et l'état de la plaquette.

Des orifices 55 réalisés dans la pièce 51, permettent de réguler la pression à l'intérieur de la partie creuse du piston 46. On a représenté en 57, des moyens qui permettent de repérer la position de la platine 27, lorsque celle-ci a amené la plaquette en position de cambrage, sur le socle 20. Ces moyens peuvent être constitués de manière connue par un contact agissant sur un relais.

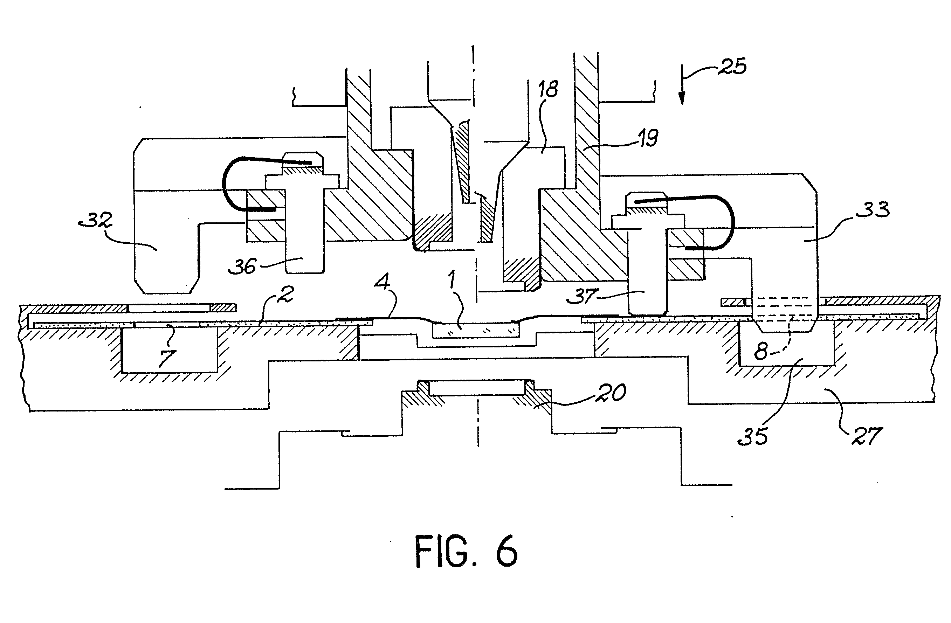

La figure 6 représente schématiquement les positions des pièces mobiles de cambrage 18, 19 et de la platine 27, par rapport au socle de position fixe 20, au début des opérations de cambrage des pattes de connexion de la plaquette 1, sur la bande support 2. On a représenté sur la partie gauche de la figure les positions initiales de ces pièces alors que la plaquette 1 vient d'être positionnée en regard du socle 20. Les saillies 32 ne sont pas encore engagées dans les perforations 7 de la bande support 2, les doigts 36 ne touchent pas encore le ruban, et la platine 27 n'est pas encore déplacée en direction du support 20. Sur la partie droite de la figure on a représenté les mêmes éléments que précédemment, les pièces mobiles 18, 19 ayant amorcé leur mouvement de descente en direction du socle 20, dans le sens de la flèche 25. Le doigt 37 entre en contact avec la bande support 2, alors que la partie 33 en saillie de la pièce mobile 19, est engagée dans la perforation 8 de la bande support 2 et dans le logement 35 de la platine 27 qui est encore dans sa position initiale, freinée par les moyens d'amortissement 29 et 56 de la figure 5.

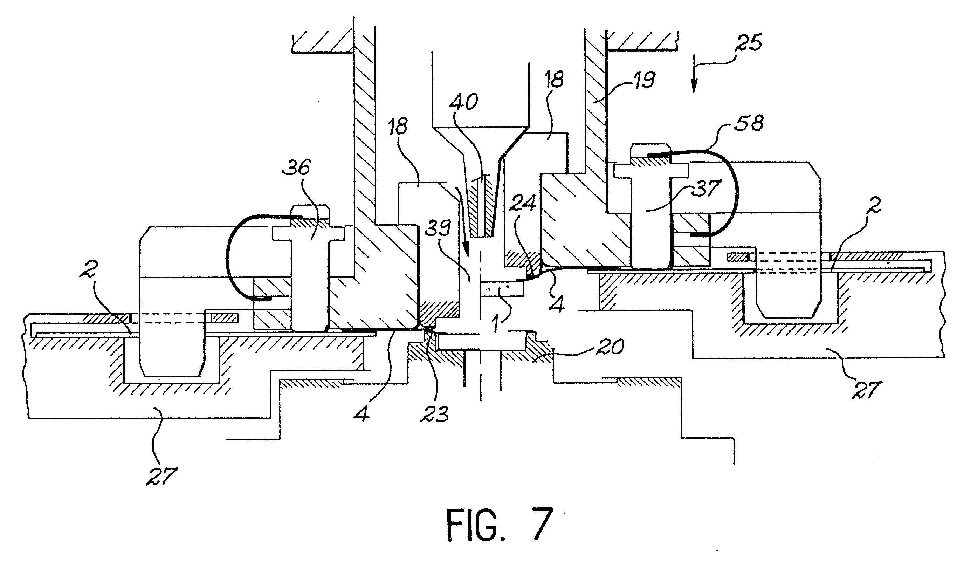

La figure 7 représente schématiquement et respectivement, à droite et à gauche, les positions des éléments précédents, au cours des deux opérations successives suivantes. La première de ces opérations, représentée sur la partie droite de la figure montre que les pièces mobiles 18 et 19, sont en contact avec les conducteurs 4 de la plaquette 1, grâce au déplacement de ces pièces dans le sens de la flèche 25. Le doigt 37 soumis à la force de rappel du ressort 58, est en contact avec le support 2 qu'il plaque ainsi sur la face supérieure de la platine 27. La platine 27 amorce son déplacement en direction du socle 20, ce déplacement étant encore freiné par les moyens d'amortissement 29 et 56, représentés sur la figure 5. Sur la partie gauche de la figure, on a représenté l'opération suivante ; le doigt 36 est bien entendu toujours au contact de la bande support 2, de manière à plaquer cette bande sur la platine 27. Le conducteur 4 arrive au contact du rebord 23 du socle 20, et la portion de conducteur située entre ce rebord et la première pièce mobile 18, commence à être coincée entre le socle 20 et la pièce mobile 18. La plaquette 1 est alors en regard du logement du support 20. L'extrémité de la buse 40 est alors dégagée du pourtour de la buse 39, de manière que soit appliqué à la plaquette 1, le jet de fluide gazeux sous pression de la buse 39 permettant de positionner et de maintenir la plaquette 1 dans le fond du logement du socle 20.

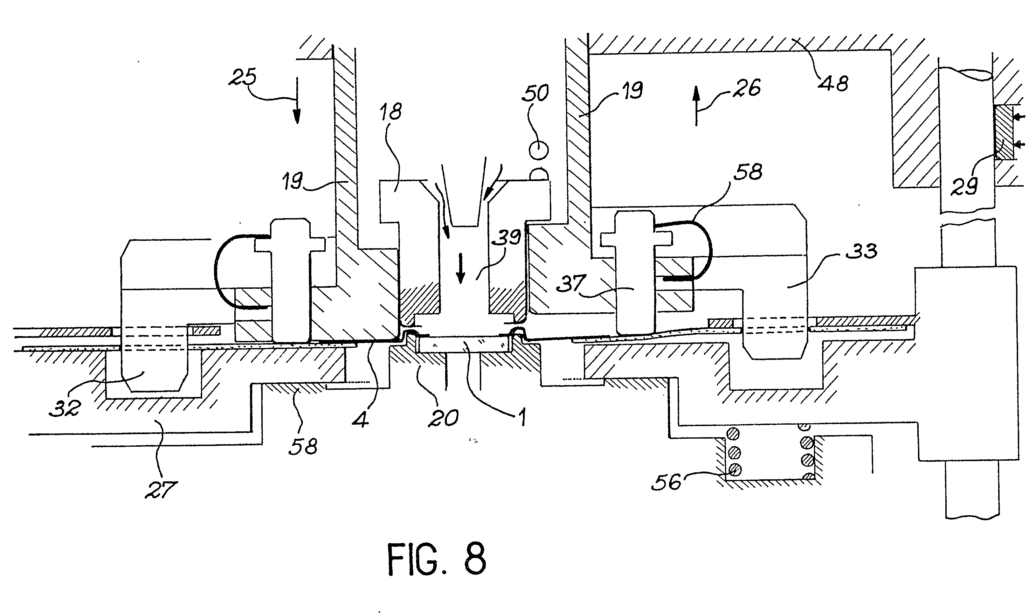

La figure 8 représente sur la partie gauche les positions des éléments précédents durant l'opération de cambrage proprement dite. La première pièce 18, sollicitée par le ressort 50, coince les conducteurs 4 entre leur extrémité et le rebord plan du socle 20 tandis que la deuxième pièce mobile 19 et la platine 27 continuent leurs mouvements en direction du socle, dans le sens de la flèche 25. Durant cette opération, les conducteurs 4 qui sont coincés entre le socle 20 et la première pièce mobile 18, subissent grâce au mouvement de la deuxième pièce mobile 19, un cambrage autour du rebord du socle 20, de la manière décrite précédemment. Il est bien entendu que le fluide gazeux sous pression continue à être appliqué sur la plaquette 1, à travers la buse 39. Durant cette opération, le mouvement de la platine 27 est constamment amorti par le frein automatique 29 et par le ressort 56. A la fin du cambrage, la platine 27 arrive en butée sur la partie 58 du bâti 48, solidaire du socle 20. La fin de course de la platine 27 ayant été détectée par le détecteur 57, on valide le contrôle du bon positionnement de la plaquette et de son état. Après ce contrôle, l'arrivée du fluide gazeux sous pression dans les buses 39 et 40 ainsi que dans le conduit 49, est arrêtée. Sur cette même figure 8 et sur la partie droite, on a représenté l'opération suivante ; les pattes de connexion viennent d'être cambrées de la manière décrite précédemment tandis que les pièces mobiles 18, 19 commencent leur mouvement de remontée dans le sens de la flèche 26. Le doigt 37, sollicité par le ressort 58, évite que la bande support 2 ne s'éloigne trop rapidement de la platine 27, tant que la partie en saillie 33 de la deuxième pièce mobile 19 n'est pas dégagée de la perforation latérale correspondante de cette bande support. Durant toute cette remontée, la platine 27 est sollicitée vers le haut grâce au ressort 56 dont la force élastique est inférieure à la force élastique des ressorts 58. En effet, il est nécessaire que la bande support soit maintenue partiellement au contact de la platine 27 durant la remontée de la pièce 19, car la partie en saillie 33 qui est engagée dans la perforation correspondante de la bande support, pourrait éventuellement entraîner cette bande vers le haut et déformer la cambrure des pattes de connexion. On n'a pas représenté en détail la remontée des pièces mobiles 18, 19 et de la platine 27 jusqu'à leur position initiale ; en effet, à partir de la dernière opération qui vient d'être décrite, cette remontée s'effectue de manière simple ; les saillies 32 et 33 sont dégagées des perforations correspondantes de la bande support 2, la platine 27 sollicitée par le ressort 56 remonte, et la plaquette 1 dont les pattes viennent d'être cambrées est dégagée du logement du support 20 ; cette platine ainsi que les pièces mobiles 18, 19 viennent occuper leur position initiale, tandis qu'éventuellement une nouvelle plaquette peut se présenter en regard du socle 20.

La figure 9 représente de manière schématique les différents moyens de commande qui sont associés à la machine de l'invention ; ces moyens de commande ne font pas partie de l'invention et ne sont pas décrits ici en détail. Sur cette figure, on a représenté en 60 un ensemble de synchronisation des différentes fonctions de la machine. Cet ensemble commande l'avance pas-à-pas du ruban 2, portant les plaquettes 1, de manière à amener successivement chacune de ces plaquettes en regard du socle 20. De manière connue, ce ruban se déroule d'une bobine 61 et s'enroule sur une bobine 62. Cet ensemble de synchronisation reçoit sur son entrée 63, divers signaux provenant par exemple du relais 56 de la figure 5 ou du détecteur 42, 43 qui permet de contrôler le bon positionnement des plaquettes en regard du socle 20. Cet ensemble de synchronisation commande également des moyens pneumatiques 64, 65 qui alimentent d'une part la chambre à air 47 à travers le conduit 49, et d'autre part les buses 39, 40 (figure 5), à travers le conduit 38. On a représenté de manière schématique en 66 un appareil d'observation microscopique qui permet de vérifier les résultats du cambrage de chacune des plaquettes, après passage dans la machine automatique conforme à l'invention et qui est représentée schématiquement en 67.

**Revendications**

1. Machine automatique de cambrage des pattes de connexion (12) d'au moins une plaquette (1) de circuits intégrés, destinée à être montée sur une plaque de connexion (10), cette plaquette étant préalablement montée sur un support isolant (2) pourvu d'au moins une fenêtre, (3) au centre de laquelle se trouve la plaquette, des conducteurs (4) reliant des plots de contact (17) de la plaquette (1) avec le support isolant (2) tout en soutenant la plaquette (1) dans la fenêtre (3), une patte représentant une portion de conducteur (4) qui s'étend du plot correspondant jusqu'au voisinage d'une structure d'amortissement (9) des contraintes mécaniques, solidaire du conducteur (4) et voisine du bord de la fenêtre (3), cette machine comprenant un socle de cambrage (20), des moyens mobiles de cambrage (18, 19) situés en regard du socle (20), des moyens (27) pour déplacer le support de plaquettes et pour amener chaque plaquette sur le socle (20) dans une direction perpendiculaire à la plaquette (1) et dans un premier sens (25), et pour éloigner la plaquette après cambrage, dans ladite direction perpendiculaire et dans un deuxième sens (26) opposé au premier sens, et des moyens (39, 40) pour positionner la plaquette sur le socle, caractérisé en ce que le socle de cambrage (20) comprend un logement (21) dont le pourtour épouse la forme du pourtour de la plaquette (1) et dont un rebord plan (23) est apte à entrer en contact avec les pattes (12) à cambrer, au voisinage du pourtour de la plaquette, et en ce que les moyens mobiles (18, 19) de cambrage comprennent une première pièce mobile (18) dans ladite direction perpendiculaire et dans les premier et deuxième sens, cette première pièce étant située en regard du socle (20) et présentant un rebord plan (24) correspondant au rebord plan (23) du socle, de manière à coincer les pattes (12) de la plaquette (1) au voisinage du pourtour de la plaquette lors du cambrage, et une deuxième pièce mobile (19) dans ladite direction perpendiculaire et dans les deux sens, cette deuxième pièce (19) entourant la première pièce (18) et permettant de cambrer les conducteurs (4) de manière à former des pattes (12) qui présentent chacune une cambrure (13) qui épouse la forme du pourtour du rebord (23) du socle (20), une partie linéaire (14) se raccordant à cette cambrure dans une direction sensiblement perpendiculaire à la plaquette, cette partie linéaire se raccordant aussi de manière continue avec la portion restante (15) de conducteur située entre cette partie linéaire et le support isolant (2), la première pièce (18) circulant dans la deuxième pièce (19) et des moyens élastiques (50) étant interposés entre ces deux pièces pour appliquer à la première pièce (19) une force s'opposant au mouvement relatif de la première pièce (18) par rapport à la deuxième (19).

2. Machine automatique selon la revendication 1, caractérisé en ce que les moyens (39, 40) pour positionner la plaquette (1) sur le socle de cambrage (20) sont constitués par des moyens pneumatiques (39) de contrôle d'état et de positionnement situés dans la première pièce (18) et appliquant sur la plaquette un jet de fluide gazeux sous pression capable d'appliquer la plaquette (1) dans son logement (21).

3. Machine automatique selon la revendication 2, caractérisée en ce que les moyens (39, 40) pour positionner la plaquette sur le socle de cambrage comprennent en outre des moyens pneumatiques (40) de contrôle de la présence de la plaquette.

4. Machine automatique selon la revendication 3, caractérisée en ce que les moyens pneumatiques de contrôle de présence sont constitués par des moyens pneumatiques (40) pour appliquer sur la plaquette un jet de fluide gazeux dont la pression est inférieure à celle du jet de fluide gazeux de contrôle d'état et de positionnement.

5. Machine automatique selon la revendication 4, caractérisée en ce que les moyens pneumatiques (40) de contrôle de présence et de contrôle d'état et de positionnement (39), comprennent en outre un capteur de pression (41) relié au logement (21) du socle, et des moyens de détection (42, 43) de seuil de pression, associés à ce capteur pour indiquer un incident et interdire le cambrage en cas de mauvais positionnement de la plaquette (1) dans le logement (21) du socle (20), en cas d'absence de plaquette ou si cette plaquette présente un mauvais état de surface.

6. Machine automatique selon la revendication 5, caractérisée en ce que la sortie (44) du détecteur (42, 43) est reliée à des moyens (61, 62) pour déplacer le support de plaquettes, de sorte à arrêter la machine en cas d'incident.

7. Machine automatique selon la revendication 6, caractérisée en ce que le support (2) de plaquette est constitué par un ruban souple isolant inextensible muni de perforations latérales (7, 8) d'entraînement, les fenêtres (3) dans lesquelles se trouvent les plaquettes se succédant dans une direction linéaire parallèle aux bords du ruban (2), les moyens (61, 62) qui permettent de déplacer le support étant constitués par un dispositif d'entraînement pas à pas agissant sur les perforations latérales (7, 8), pour déplacer le ruban (2) dans ladite direction linéaire, pour amener successivement chaque plaquette (1) en regard de ce socle (20), les moyens (27) pour amener la plaquette sur le socle de cambrage comprenant une platine (27) de positionnement du ruban, cette platine présentant des moyens de guidage (28, 30) linéaire du mouvement avec amortissement dans ladite direction perpendiculaire à la plaquette dans les premier et deuxième sens (25, 26) et présentant une ouverture (31) en regard du logement (21) du socle de cambrage, la deuxième pièce mobile (19) de cambrage présentant des saillies (32, 33) aptes à s'engager dans les perforations (7, 8) de la bande (2) qui sont voisines de chaque plaquette (1) située en regard du socle (20) de cambrage, et aptes à s'engager dans des logements (34, 35) réalisés dans la platine (27) de positionnement en regard de ces saillies, cette deuxième pièce de cambrage (18) comprenant en outre des moyens élastiques (36, 37) aptes à plaquer le ruban (2) sur la platine (27) de positionnement, lors du déplacement des première et deuxième pièces (18, 19) dans le premier sens (25) pour le cambrage et lors du déplacement de ces pièces dans le deuxième sens (26), jusqu'à ce que les saillies (32, 33) soient dégagées des perforations (7, 8) après cambrage.

8. Machine automatique selon la revendication 7, caractérisée en ce que les moyens de guidage linéaire et d'amortissement (28, 29, 30) du mouvement de la platine (27) comprennent un guide linéaire (30) solidaire de cette platine (27) et parallèle à ladite direction perpendiculaire à la plaquette, et des moyens élastiques d'amortissement (56) du mouvement, situés entre la platine et un bâti (48) solidaire du socle de cambrage (20).

9. Machine automatique selon la revendication 8, caractérisée en ce que les moyens d'amortissement comprennent en outre un frein pneumatique (29) agissant sur le guide linéaire (30).

10. Machine automatique selon la revendication 7, caractérisée en ce que les moyens élastiques (36, 37) pour plaquer le ruban (2) sur la platine de positionnement (27), sont constitués par des doigts munis de ressorts, montés dans la deuxième pièce mobile (18) de cambrage et agissant dans ladite direction perpendiculaire à la plaquette.

11. Machine automatique selon la revendication 7, caractérisée en ce qu'elle comprend des moyens pneumatiques (47) de commande des déplacements des première et deuxième pièces mobiles (18, 19) de cambrage dans la direction perpendiculaire à la plaquette et dans les premier et deuxième sens (25, 26).

12. Machine automatique selon la revendication 7, caractérisée en ce que les moyens pneumatiques de contrôle d'état et de positionnement (39) situés dans la première pièce mobile (18) sont constitués par une première buse (39) formée dans la première pièce mobile et alimentée par le fluide gazeux sous pression.

13. Machine automatique selon la revendication 12, caractérisée en ce que les moyens pneumatiques de contrôle de présence de plaquette par pression de fluide gazeux comprennent une seconde buse (40) située dans la première buse (39) présentant un orifice de dimension inférieure à celle de la première buse et alimentée par le même fluide gazeux sous pression, le logement (21) du socle comprenant un conduit (45) relié au capteur de pression (41).

### Claims

1. Automatic machine for bending connecting lugs (12) of at least one intergrated circuit chip (1) intended to be installed on a connecting board (10), this chip previously being placed on an insulating support (2) provided with at least one opening (3) at whose centre the chip is situated, conductors (4) connecting contact members (17) of the chip (1) to the insulating support (2) whilst supporting the chip (1) within the housing (3), a lug representing a conductor portion (4) which extends from the corresponding contact member up to a structure (9) for damping mechanical stresses integral with the conductor (4) and close to the edge of the opening (3), this machine comprising a bending base (20), movable bending means (18, 19) positioned opposite the base (20), means (27) for displacing the chip support and for bringing each chip on to the base (20) in a direction perpendicular to the chip (1) and in a first direction (25) and for with drawing the chip after the bending action in the said perpendicular direction and in a second direction (26) opposed to the first direction, and means (39, 40) for positioning the chip on the base, characterised in that the bending base (20) has a seat (21) of which the outline follows the form of the outline of the chip (1) and of which a plane rim (23) is able to come into contact with the lugs (12) which are to be bent, close to the periphery of the chip, and in that the movable bending means (18, 19) comprise a first member (18) movable in the said perpendicular direction and in the said first and second directions, this first member being situated opposite the base (20) and having a plane rim (24) corresponding to the plane rim (23) of the base, in such a manner as to grip the lugs (12) of the chip (1) close to the periphery of the chip during the bending action, and a second member (19) movable in the said perpendicular direction and in the two directions, this second member (19) surrounding the first member (18) and permitting bending of the conductors (4) in such a manner as to form lugs (12) of which each has a curvature (13) following the form of the outline of the rim (23) of the base (20), a linear portion (14) being joined to this curvature in a direction substantially perpendicular to the chip, this linear portion also being joined in continuous manner to the residual portion (15) of the conductor situated between this linear portion and the insulating support (2), the first member (18) running in the second member (19) and resilient means (50) being interposed between these two members to apply to the first member (19) a force opposed to the relative displacement of the first member (18) with respect to the second member (19).

2. Automatic machine according to claim 1, characterised in that the means (39, 40) for positioning the chip (1) on the bending base (20) are formed by pneumatic means (39) for controlling the state and positioning, situated in the first member (18) and applying to the chip a jet of gaseous fluid under pressure which is able to apply the chip (1) in its location (21).

3. Automatic machine according to claim 2, characterised in that the means (39, 40) for positioning the chip on the bending base also comprise pneumatic means (40) for checking on the presence of the chip.

4. Automatic machine according to claim 3, characterised in that the pneumatic means for checking on the presence are formed by pneumatic means (40) for applying to the chip a jet of gaseous fluid of which the pressure is lower than that of the jet of gaseous fluid for checking on condition and positioning.

5. Automatic machine according to claim 4, characterised in that the pneumatic means (40) for checking on the presence and the means (39) for checking on state and positioning, furthermore comprise a pressure detector (41) connected to the seat (21) for the foot and pressure threshold detection means (42, 43) associated with this detector for indication of an incident and for prevention of the bending action in the case of improper positioning of the chip (1) in the seat (21) of the base (20), in the case of absence of a chip or if this chip displays a poor surface condition.

6. Automatic machine according to claim 5, characterised in that the output (44) of the detector (42, 43) is connected to means (61, 62) for displacing the chip support, in such manner as to stop the machine in case of an incident.

7. Automatic machine according to claim 6, characterised in that the chip support (2) is formed by inextensible and flexible insulating strip equipped with lateral driving perforations (7, 8), the openings (3) wherein the chips are placed following each other in a linear direction parallel to the edges of the strip (2), the means (61, 62) enabling the support to be displaced being formed by a step-by-step driving device acting on the lateral perforations (7, 8) to displace the strip (2) in the said linear direction, so as to bring each chip (1) successively into alignment with this base (20), the means (27) for bringing the chip on to the bending base comprising a strip positioning plate (27), this plate having means (28, 30) for linear guiding of the displacement with damping action in the said direction perpendicular to the chip, in the first and second directions (25, 26) and having an opening (31) opposite the seat (2) of the bending foot, the second movable bending member (19) having projections (32, 33) able to engage in the perforations (7, 8) of the strip (2) which are close to each chip (1) positioned opposite the bending foot (20) and able to engage in locations (34, 35) formed in the positioning plate (27) in alignment with these projections, this second bending member (18) furthermore comprising resilient means (36, 37) able to apply the strip (2) on to the positioning plate (27) during the displacement of the first and second members (18, 19) in the first direction (25) for the bending action and during the displacement of these members in the second direction (26) until the projections (32, 33) are withdrawn from the perforations (7, 8) after a bending action.

8. Automatic machine according to claim 7, characterised in that the means (28, 29, 30) for linear guiding and damping of the displacement of the plate (27) comprise a linear guide (30) integral with this plate (27) and parallel to the said direction perpendicular to the chip and resilient displacement damping means (56) situated between the plate and a structure (48) integral with the bending foot (20).

9. Automatic machine according to claim 8, characterised in that the damping means furthermore comprise a pneumatic brake (29) acting on the linear guide (30).

10. Automatic machine according to claim 7, characterised in that the resilient means (36, 37) for applying the strip (2) on to the positioning plate (27) are formed by fingers equipped with springs, installed in the second movable bending member (18) and acting in the said direction perpendicular to the chip.

11. Automatic machine according to claim 7, characterised in that it comprises pneumatic means (47) for controlling the displacements of the first and second movable bending members (18, 19) in the direction perpendicular to the chip and in the first and second directions (25, 26).

12. Automatic machine according to claim 7, characterised in that the pneumatic means for checking on state and positioning (39) situated in the first movable member (18) are constituted by a first nozzle (39) formed in the first movable member and supplied with the gaseous fluid under pressure.

13. Automatic machine according to claim 12, characterised in that the pneumatic means for checking on the presence of a chip by gaseous fluid pressure comprise a second nozzle (40) situated in the first nozzle (39) having an orifice of smaller size than that of the first nozzle and supplied with the same gaseous fluid under pressure, the seat (21) of the base comprising a passage (45) connected to the pressure detector (41).

**Ansprüche**

1. Automatische Maschine zum Wölben der Anschlußstreifen (12) wenigstens eines Plättchens (1) von integrierten Schaltungen, das auf einer Anschlußplatte (10) montiert werden soll, wobei dieses Plättchen zuvor auf einem isolierenden Träger (2) befestigt wird, der mit wenigstens einem Fenster (3) versehen ist, in dessen Mitte sich das Plättchen befindet, wobei die Kontaktklötzchen (17) des Plättchens (1) mit dem isolierenden Träger (2) durch Leiter (4) verbunden sind, welche das Plättchen (1) in dem Fenster (3) halten, wobei ein Streifen einen Teil eines Leiters (4) darstellt, der sich von dem entsprechenden Klötzchen bis zur Nähe einer Dämpfungsstruktur (9) zur Dämpfung mechanischer Beanspruchungen erstreckt, die mit dem Leiter (4) fest verbunden und dem Rand des Fensters (3) benachbart ist, wobei diese Maschine einen Wölbungssockel (20), bewegliche Wölbungsmittel (18, 19), die gegenüber dem Sockel (20) angeordnet sind, Mittel (27) zum Bewegen des Plättchenträgers und zum Zuführen jedes Plättchens auf den Sockel (20) in einer Richtung senkrecht zu dem Plättchen (1) sowie in einem ersten Sinn (25) und zum Entfernen des Plättchens nach dem Wölben in der genannten senkrechten Richtung, aber in einem zweiten, zum ersten entgegengesetzten Sinn (26) und Mittel (39, 40) zum Positionieren des Plättchens auf dem Sockel umfaßt, dadurch gekennzeichnet, daß der Wölbungssockel (20) einen Aufnahmeraum (21) umfaßt, dessen Umfang an die Form des Umfangs des Plättchens (1) angeschmiegt ist und wovon ein ebener Rand (23) geeignet ist, um mit den zu wölbenden Streifen (12) in der Nähe des Umfangs des Plättchens in Berührung zu kommen, und daß die beweglichen Wölbungsmittel (18, 19) ein erstes Teil (18) umfassen, das in der genannten senkrechten Richtung und in dem ersten sowie in dem zweiten Sinn beweglich ist, wobei dieses erste Teil gegenüber dem Sockel (20) liegt und einen ebenen Rand (24) aufweist, welcher dem ebenen Rand (23) des Sockels entspricht, so daß die Streifen (12) des Plättchens (1) in der Nähe des Umfangs des Plättchens beim Wölben eingeklemmt werden, und ein zweites Teil (19) umfassen, das in der genannten senkrechten Richtung und in den beiden Sinnen bewegbar ist, wobei dieses zweite Teil (19) das erste Teil (18) umgibt und die Wölbung der Leiter (4) derart gestattet, daß Streifen (12) geformt werden, die jeweils eine Wölbung (13) aufweisen, welche an die Form des Umfangs des Randes (23) des Sockels (20) angeschmiegt ist, wobei ein linienförmiges Teil (14) an diese Wölbung in einer zu dem Plättchen im wesentlichen senkrechten Richtung anschließt und dieses linienförmige Teil ferner kontinuierlich an den verbleibenden Teil (15) des Leiters anschließt, der zwischen diesem linienförmigen Teil und dem isolierenden Träger (2) liegt, wobei ferner das erste Teil (18) in dem zweiten Teil (19) zirkuliert und elastische Mittel (50) zwischen diesen beiden Teilen eingefügt sind, um auf das erste Teil (19) eine Kraft auszuüben, welche der Relativbewegung des ersten Teils (18) zu dem zweiten Teil (19) entgegengesetzt ist.

2. Automatische Maschine nach Anspruch 1, dadurch gekennzeichnet, daß die Mittel (39, 40) zum Positionieren des Plättchens (1) auf dem Wölbungssockel (20) durch pneumatische Mittel (39) zur Steuerung des Zustands und der Positionierung gebildet sind, welche in dem ersten Teil (18) angeordnet sind und das Plättchen mit einem Druckgasstrahl beaufschlagen, der imstande ist, das Plättchen (1) in seinen Aufnahmeraum (21) einzudrücken.

3. Automatische Maschine nach Anspruch 2, dadurch gekennzeichnet, daß die Mittel (39, 40) zum Positionieren des Plättchens auf dem Wölbungssockel ferner pneumatische Mittel (40) zur Steuerung der Anwesenheit des Plättchens umfassen.

4. Automatische Maschine nach Anspruch 3, dadurch gekennzeichnet, daß die pneumatischen Mittel zur Steuerung der Anwesenheit gebildet sind durch pneumatische Mittel (40) zum Beaufschlagen des Plättchens mit einem Gasstrahl, dessen Druck geringer als derjenige des Gasstrahls zur Steuerung des Zustands und der Positionierung ist.

5. Automatische Maschine nach Anspruch 4, dadurch gekennzeichnet, daß die pneumatischen Mittel (40) zur Steuerung der Anwesenheit und zur Steuerung des Zustands sowie der Positionierung (39) ferner einen Druckfühler (41) umfassen, der mit dem Aufnahmeraum (21) des Sockels verbunden ist, und Druckschwellwert-Detektionsmittel (42, 43) umfassen, die diesem Fühler zugeordnet sind, um einen Zwischenfall anzuzeigen und das Wölben für den Fall einer falschen Positionierung des Plättchens (1) in dem Aufnahmeraum (21) des Sockels (20), bei Fehlen eines Plättchens oder bei schlechter Oberflächenbeschaffenheit dieses Plättchens zu unterbinden.

6. Automatische Maschine nach Anspruch 5, dadurch gekennzeichnet, daß der Ausgang (44) des Detektros (42, 43) mit Mitteln (61, 62) zum Bewegen des Trägers der Plättchen verbunden ist, so daß die Maschine beim Auftreten eines Zwischenfalls angehalten wird.

7. Automatische Maschine nach Anspruch 6, dadurch gekennzeichnet, daß der Träger (2) des Plättchens aus einem flexiblen, isolierenden und undehnbaren Band gebildet ist, welches mit seitlichen Mitnahmeperforierungen (7, 8) versehen ist, wobei die Fenster (3), in denen die Plättchen angeordnet sind, in einer linienförmigen Richtung parallel zu den Rändern des Bandes (2) aufeinanderfolgen, wobei die Mittel (61, 62) zur Bewegung des Trägers durch eine Schritt für Schritt arbeitende Antriebsvorrichtung gebildet sind, die auf die seitlichen Perforierungen (7, 8) einwirkt, um das Band (2) in der genannten linienförmigen Richtung zu bewegen und nacheinander jedes Plättchen (1) in Gegenüberstellung zu dem Sockel (20) zu bringen, wobei die Mittel (27) zum Befördern des Plättchens auf den Wölbungssockel eine Positionierscheibe (27) zur Positionierung des Bandes umfassen, welche lineare Führungsmittel (28, 30) zur Führung der Bewegung mit Dämpfung in der genannten, zu dem Plättchen senkrechten Richtung in dem ersten sowie in dem zweiten Sinn (25, 26) und eine Öffnung (31) gegenüber dem Aufnahmeraum (21) des Wölbungssockels umfaßt, wobei das zweite bewegliche Wölbungsteil (19) Vorsprünge (32, 33) aufweist, die geeignet sind, um in die Perforierungen (7, 8) des Bandes (2) einzugreifen, die jeweils einem Plättchen (1) benachbart sind, welches sich gegenüber dem Wölbungssockel (20) befindet, und geeignet sind, um in Aussparungen (34, 35) einzugreifen, welche in der Positionierscheibe (27) gegenüber diesen Vorsprüngen angebracht sind, wobei das zweite Wölbungsteil (18) ferner elastische Mittel (36, 37) umfaßt, die geeignet sind, das Band (2) gegen die Positionierscheibe (27) während der Bewegung des ersten und des zweiten Teils (18, 19) in dem ersten Sinn (25) zum Wölben und während der Bewegung dieser Teile in dem zweiten Sinn (26) angelegt zu halten, bis die Vorsprünge (32, 33) aus den Perforierungen (7, 8) nach dem Wölben freigekommen sind.

8. Automatische Maschine nach Anspruch 7, dadurch gekennzeichnet, daß die linearen Führungs- und Dämpfungsmittel (28, 29, 30) für die Bewegung der Scheibe (27) eine lineare Führung (30) umfassen, welche mit dieser Scheibe (27) fest verbunden und parallel zu der genannten, zu dem Plättchen senkrechten Richtung ist, sowie elastische Bewegungsdämpfungsmittel (56) umfassen, die zwischen der Scheibe und einem Aufbau (48) angeordnet sind, welcher mit dem Wölbungssockel (20) fest verbunden ist.

9. Automatische Machine nach Anspruch 8, dadurch gekennzeichnet, daß die Dämpfungsmittel ferner eine pneumatische Bremse (29) umfassen, welche auf die lineare Führung (30) einwirkt.

10. Automatische Maschine nach Anspruch 7, dadurch gekennzeichnet, daß die elastischen Mittel (36, 37) zum Anlegen des Bandes (2) gegen die Positionierscheibe (27) durch Finger gebildet sind, die mit Federn versehen sind, welche in dem zweiten beweglichen Wölbungsteil (18) angebracht sind und in der genannten, zu dem Plättchen senkrechten Richtung wirken.

11. Automatische Maschine nach Anspruch 7, dadurch gekennzeichnet, daß sie pneumatische Mittel (47) zur Steuerung der Bewegungen des ersten und des zweiten beweglichen Wölbungsteils (18, 19) in der zu dem Plättchen senkrechten Richtung und in dem ersten sowie in dem zweiten Sinn (25, 26) umfaßt.

12. Automatische Maschine nach Anspruch 7, dadurch gekennzeichnet, daß die pneumatischen Mittel zur Steuerung des Zustands und der Positionierung (39), die in dem ersten beweglichen Teil (18) angeordnet sind, durch eine erste Düse (39) gebildet sind, welche in dem ersten beweglichen Teil gebildet ist und durch das unter Druck stehende Gas gespeist wird.

13. Automatische Maschine nach Anspruch 12, dadurch gekennzeichnet, daß die pneumatischen Mittel zur Steuerung der Anwesenheit des Plättchens durch den Druck eines Gases eine zweite Düse (40) umfassen, welche innerhalb der ersten Düse (39) angeordnet ist und eine kleinere Öffnung als die erste Düse aufweist sowie durch dasselbe unter Druck stehende Gas gespeist wird, wobei der Aufnahmeraum (21) des Sockels eine Leitung (45) umfaßt, welche mit dem Druckfühler (41) verbunden ist.

FIG. 1

FIG. 4

FIG. 2

FIG. 3

FIG. 9

FIG. 5

FIG. 6

0 053 966

FIG. 7

FIG. 8